# EUROPEAN PATENT APPLICATION

(11) **EP 2 942 808 A1**
(43) Date of publication of application: **11.11.2015**
(21) Application number: 13870042.2
(22) Date of filing: 17.12.2013
(51) Int. Cl.: H01L 23/13, B22F 3/26, B22F 7/06, C22C 5/02, C22C 5/06, C22C 9/00, C22C 27/04, H05K 1/09, H05K 3/40

(54) **CERAMIC WIRING SUBSTRATE, SEMICONDUCTOR DEVICE, AND METHOD FOR MANUFACTURING CERAMIC WIRING SUBSTRATE**

(30) Priority: 07.01.2013 JP 2013000431
(71) Applicant: A.L.M.T. Corp., Minato-ku Tokyo 105-0014 (JP)
(72) Inventor: HIROSE, Yoshiyuki, Itami-shi Hyogo 664-0016 (JP); SUGITANI, Sachie, Itami-shi Hyogo 664-0016 (JP); GOMA, Norihito, Itami-shi Hyogo 664-0016 (JP); TOYOSHIMA, Gouhei, Sakata-shi Yamagata 998-0114 (JP); UENISHI, Noboru, Itami-shi Hyogo 664-0016 (JP)
(74) Representative: Boult Wade Tennant
(86) International application number: PCT/JP2013/083760
(87) International publication number: WO 2014/106925

(57) **Abstract**

There is provided a ceramic wiring substrate and a method for manufacturing the same, the ceramic wiring substrate having an up-and-down conduction body which is made by forming a porous structure body made of a high melting point metal and then infiltrating a low-resistance metal in an up-and-down conduction hole subsequently formed in a substrate made in a plate shape through sintering a ceramic precursor, the up-and-down conduction body further having a normal composite structure without an abnormally grown particle, a void, a crack and the like and not having a problem of falling off from the substrate, as well as provided a semiconductor device configured by using this ceramic wiring substrate. An intermediate layer 5 formed of at least one selected from a group consisting of Mo, W, Co, Fe, Zr, Re, Os, Ta, Nb, Ir, Ru and Hf is formed on an inner surface of the up-and-down conduction hole 2 of the substrate 3 before being provided with the up-and-down conduction body 4 having the composite structure.

## Description

### Technical Field

The present invention relates to a ceramic wiring substrate comprising a substrate formed in a plate shape from ceramic containing at least Al or Si, and an up-and-down conduction body which penetrates the substrate in a thickness direction, and a semiconductor device using the ceramic wiring substrate.

### Background Art

A ceramic wiring substrate, where an up-and-down conduction hole penetrating in a thickness direction is formed in a predetermined position of a substrate formed in a plate shape from ceramic such as AlN, Al₂O₃ or SiC, for example, and is filled with an up-and-down conduction body (via), is used for mounting a semiconductor element and for other purposes.

Generally, such a ceramic wiring substrate is formed in such a manner that in order to improve a positional accuracy of the up-and-down conduction hole, a plate body of a precursor which is to become ceramic (ceramic green sheet) is first sintered to form a substrate, then, an up-and-down conduction hole penetrating in a thickness direction of the substrate is formed in a predetermined position of the substrate, and thereafter, the up-and-down conduction hole is filled with an up-and-down conduction body formed of a conductive material.

However, when an entirety of the up-and-down conduction body is formed of a low-resistance metal such as Cu, Ag or Au as the conductive material, thermal expansion coefficients of the low-resistance metal and ceramic are significantly different. Therefore, when the substrate is subjected to a high temperature in a joint process where a semiconductor element is mounted on the substrate, a tip surface of the up-and-down conduction body which is usually coincident with a surface of the substrate protrudes outward of the surface of the substrate and then recovers by cooling along with expansion and contraction of the up-and-down conduction body.

There is a problem that a local stress is applied due to the above behavior to a metallized layer or a solder layer which are formed on the surface of the substrate including the tip surface of the up-and-down conduction body and are used for junction with the semiconductor element and for other purposes, whereby a crack is prone to be formed in these layers, and that when the crack is formed, reliability of mounting of the semiconductor element is significantly reduced. Moreover, there may be a problem that a large thermal stress is applied to the substrate itself and the mounted semiconductor element.

Accordingly, it has been reviewed that the up-and-down conduction body is made to have a composite structure where a porous structure body formed of a high melting point metal such as W or Mo is filled with a low-resistance metal such as Cu, Ag or Au, thereby to make a thermal expansion coefficient thereof closer to that of the substrate formed of ceramic.

In patent literature 1, for example, a paste containing a powder of a high melting point metal such as W or Mo is filled in an up-and-down conduction hole, and the powder is sintered, thereby to form a porous structure body formed of the high melting point metal, and thereafter, a low-resistance metal such as Cu, Ag or Au is infiltrated into the porous structure body, whereby an up-and-down conduction body having the above composite structure is formed.

However, such a structure has a problem that since the porous structure body formed of the high melting point metal is not adhered to a substrate formed of ceramic, the up-and-down conduction body is prone to fall off from the substrate.

When a glass component is contained in a high melting point metal, adherence between a porous structure body and a substrate is improved. However, in a process of infiltrating a low-resistance metal thereafter, the low-resistance metal is not adhered to glass in the porous structure body or ceramic forming the substrate. Therefore, there is a problem that a void is prone to be created in an inside of an up-and-down conduction body and an interface with the substrate.

Further, according to a study of the Applicant, with respect to a process where a high melting point metal is sintered to form a porous structure body and a process where a low-resistance metal is infiltrated into a porous structure body both of which are performed in a reducing gas atmosphere such as H₂ or in a vacuum to prevent oxidation, when a temperature rises to more than 900 °C, particularly to around 1,000 °C, by heating at these processes, Al or Si forming a substrate are diffused due to the heat into an up-and-down conduction body which is under formation.

Further, there is caused a problem that a favorable up-and-down conduction body having a normal composite structure cannot be formed because
diffused Al or Si react at a high temperature of 900 °C or more to cause partial abnormal growth of Mo or W, thereby to produce an abnormally grown particle,
infiltration of the low-resistance metal into the porous structure body is inhibited by the abnormally grown particle, and the low-resistance metal cannot go uniformly round into the porous structure body, thereby to cause a void or a crack, or
Al or Si react with the low-resistance metal to produce gas, thereby to cause a void.

Patent literature 2 describes that after an up-and-down conduction hole is formed in a ceramic green sheet before sintering and then is filled with a paste containing a powder of a high melting point metal such as W or Mo, an entirety is sintered to form integrally a ceramic substrate and a porous structure body filled in the up-and-down conduction hole of the substrate, and that thereafter, a molten low-resistance metal such as Cu is made to permeate into the porous structure body by a weight of a load plate, thereby to form an up-and-down conduction body.

According to this method, adherence between the substrate and the porous structure body is improved. However, since the low-resistance metal and ceramic are not yet adhered, the problem that a void is prone to be created in an interface between the up-and-down conduction body and the substrate is not solved.

Further, since the ceramic green sheet which is to become the substrate is previously provided with the up-and-down conduction hole and then is sintered, there is a problem that a positional accuracy of the up-and-down conduction hole is lowered due to uneven contraction of the ceramic green sheet at the time of sintering.

Patent literature 3 describes that after an up-and-down conduction hole is formed in a ceramic green sheet also before sintering and then is filled with a paste containing a powder of a high melting point metal such as W or Mo and a powder of a low-resistance metal such as Cu, an entirety is sintered to form integrally a ceramic substrate and an up-and-down conduction body having a composite structure of the high melting point metal and the low-resistance metal which are filled in the up-and-down conduction hole thereof.

According to this method, it is expected that adherence between the substrate and the up-and-down conduction body is improved to prevent creation of a void. However, in this method, a sintering temperature is further higher and 1500 °C or more, and Al or Si forming the substrate are in reality diffused into the up-and-down conduction body during sintering, as described above. Therefore, creation of a void is inevitable. Further, since the ceramic green sheet which is to become the substrate is also previously provided with the up-and-down conduction hole and then is sintered, the problem that a positional accuracy of the up-and-down conduction hole is lowered due to uneven contraction of the ceramic green sheet at the time of sintering cannot be solved.

### Citation List

### Patent Literature

Patent literature 1: Japanese Examined Patent Publication No. 07-101724
Patent literature 2: Japanese Unexamined Patent Publication No. 05-267849
Patent literature 3: Japanese Unexamined Patent Publication No. 2000-22338

### Summary of Invention

### Technical Problem

An object of the present invention is to provide a ceramic wiring substrate and a method for manufacturing the same, the ceramic wiring substrate having an up-and-down conduction body which is made by first forming a porous structure body made of a high melting point metal in an up-and-down conduction hole subsequently formed in a substrate made in a plate shape through sintering a ceramic precursor in order to improve a positional accuracy and then infiltrating a low-resistance metal, the up-and-down conduction body further having a normal composite structure without an abnormally grown particle, a void, a crack and the like as well as not having a problem of falling off from the substrate.

Further, the present invention aims at providing a semiconductor device in which a semiconductor element is mounted on such a ceramic wiring substrate and which has a high reliability.

### Solution to Problem

The present invention is
a ceramic wiring substrate, comprising:
a substrate formed in a plate shape by sintering a ceramic precursor including at least one selected from a group consisting of Al and Si;
an up-and-down conduction hole formed by penetrating the substrate in a thickness direction thereof after sintering the substrate;
an up-and-down conduction body which is formed of a composite material including at least one low-resistance metal selected from a group consisting of Cu, Ag and Au and at least one high melting point metal selected from a group consisting of W and Mo, and is filled in the up-and-down conduction hole; and
an intermediate layer which is provided by separating the up-and-down conduction body and the substrate therebetween and is formed of at least one selected from a group consisting of Mo, W, Co, Fe, Zr, Re, Os, Ta, Nb, Ir, Ru and Hf.

Further, the present invention is
a method for manufacturing the ceramic wiring substrate of the above-described present invention, including steps of:
forming the substrate by sintering a plate body of a precursor which is to become ceramic forming the substrate;
forming an up-and-down conduction hole by penetrating the substrate in a thickness direction thereof;
forming the intermediate layer made of at least one selected from a group consisting of Mo, W, Co, Fe, Zr, Re, Os, Ta, Nb, Ir, Ru and Hf on an inner surface of the up-and-down conduction hole;
filling in the up-and-down conduction hole a paste including a powder of the at least one high melting point metal selected from a group consisting of W and Mo, and sintering the powder, thereby to form a porous structure body made of the high melting point metal; and
forming the up-and-down conduction body by infiltrating the at least one low-resistance metal selected from a group consisting of Cu, Ag and Au into the porous structure body.

According to the present invention, the intermediate layer which is formed on the inner surface of the up-and-down conduction hole of the substrate and is made of at least one selected from a group consisting of Mo, W, Co, Fe, Zr, Re, Os, Ta, Nb, Ir, Ru and Hf can prevent that Al or Si forming the substrate are diffused into the up-and-down conduction body, or contrary, that the low-resistance metal in the up-and-down conduction body is diffused into the substrate due to heat when the porous structure body is formed by sintering the high melting point metal and when the up-and-down conduction body is formed by infiltrating the low-resistance metal into the porous structure body.

As a result, according to the present invention, there can be formed a favorable up-and-down conduction body having a normal composite structure without an abnormally grown particle, a void, a crack and the like which are created when Al or Si forming the substrate are diffused into the up-and-down conduction body, and contrary, when the low-resistance metal in the up-and-down conduction body is diffused into the substrate.

Further, the intermediate layer formed of the above various elements has favorable adherence to the substrate, and moreover, reacts favorably with the up-and-down conduction body which is a composite body of the low-resistance metal and the high melting point metal. Further, there can be eliminated a clearance which is created when the up-and-down conduction body cannot follow an irregularity on the inner surface of the up-and-down conduction hole.

Accordingly, it can be also possible that adherence between the substrate and the up-and-down conduction body is improved by interposing such an intermediate layer thereby to prevent the up-and-down conduction body from falling off from the substrate.

It is preferable that a thickness of the intermediate layer is 0.01 µm or more.

Depending on a surface roughness of the inner surface of the up-and-down conduction hole, when the thickness is less than this range, there may be a problem that there are created a portion whose thickness is too thin to sufficiently prevent diffusion of Al or Si and a portion where the intermediate layer is not formed, and that the function due to the intermediate layer to prevent Al or Si forming the substrate from diffusing into the up-and-down conduction body, and contrary, to prevent the low-resistance metal in the up-and-down conduction body from diffusing into the substrate is insufficient, and that therefore, an up-and-down conduction body having a normal composite structure without an abnormally grown particle, a void, a crack and the like cannot be formed. Further, there may be a problem that the effect due to the intermediate layer to improve the adherence between the substrate and the up-and-down conduction body is insufficient whereby the up-and-down conduction body is prone to fall off from the substrate.

Contrary to this, by making the thickness of the intermediate layer 0.01 µm or more, the above-described function due to the intermediate layer is sufficiently expressed to make it possible to form an up-and-down conduction body having a normal composite structure where an abnormally grown particle, a void, a crack and the like are further effectively prevented, and the up-and-down conduction body can be further reliably prevented from falling off from the substrate.

It is preferable that the substrate comprises a solder layer on at least one flat surface,
a thickness of the solder layer is 8 µm or less, and
a proportion of the low-resistance metal in the up-and-down conduction body is 50 % or less.

If the thickness of the solder layer is thin and 8 µm or less and the proportion of the low-resistance metal has a high density of more than 50 %, a local stress applied to the solder layer by expansion and contraction of the up-and-down conduction body is relatively larger, and therefore, there is a higher risk that the solder layer has a crack. Contrary, if the proportion of the low-resistance metal is made 50 % or less when the thickness of the solder layer is 8 µm or less, the expansion and contraction of the up-and-down conduction body is suppressed whereby it can be more reliably prevent that a crack is created in the solder layer.

The present invention is a semiconductor device wherein a semiconductor element is mounted on the above-described ceramic wiring substrate of the present invention.

According to the present invention, a semiconductor device can be mounted with high reliability on the above-described ceramic wiring substrate of the present invention via a metallized layer or a solder layer even without creating a crack in these layers or causing problems of the up-and-down conduction body such as falling off and a void.

### Effects of the Invention

According to the present invention, there can be provided a ceramic wiring substrate and a method for manufacturing the same, the ceramic wiring substrate having an up-and-down conduction body which is made by first forming a porous structure body made of a high melting point metal in an up-and-down conduction hole subsequently formed in a substrate made in a plate shape through sintering a ceramic precursor in order to improve a positional accuracy and then infiltrating a low-resistance metal, the up-and-down conduction body further having a normal composite structure without an abnormally grown particle, a void, a crack and the like and not having a problem of falling off from the substrate.

Further, according to the present invention, there can be provided a semiconductor device in which a semiconductor element is mounted on such a ceramic wiring substrate and which has a high reliability.

### Brief Description of Drawings

Fig. 1 is a sectional view showing an enlarged portion of an exemplary embodiment of a ceramic wiring substrate of the present invention.
Fig. 2 is a sectional view showing an enlarged portion of a semiconductor device where a semiconductor element is mounted on the ceramic wiring substrate of the example of Fig. 1.

### Description of Embodiment

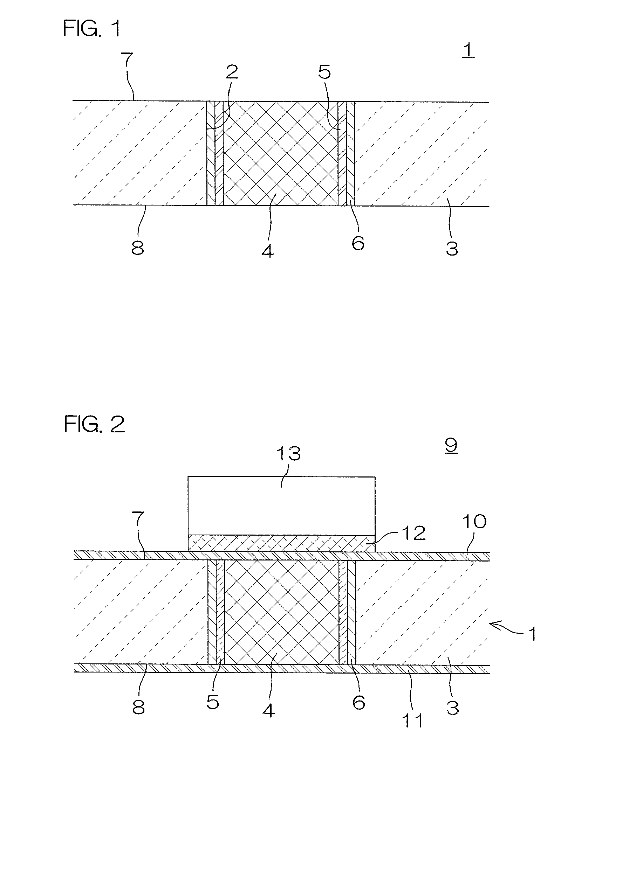

Fig. 1 is a sectional view showing an enlarged portion of an exemplary embodiment of a ceramic wiring substrate of the present invention.

Referring to Fig. 1, a ceramic wiring substrate 1 of this example comprises a substrate 3 formed in a plate shape by sintering a ceramic precursor, an up-and-down conduction hole 2 formed by penetrating the substrate 3 in a thickness direction thereof after the sintering, an up-and-down conduction body 4 which is formed of a composite material including a low-resistance metal and a high melting point metal and is filled in the up-and-down conduction hole 2, and an intermediate layer 5 formed between the up-and-down conduction body 4 and the substrate 3 in a manner to separate both of these.

As described above, the intermediate layer 5 is formed of at least one selected from a group consisting of Mo, W, Co, Fe, Zr, Re, Os, Ta, Nb, Ir, Ru and Hf.

Additionally, a reference numeral 6 is an adhesive layer which may be interposed between the intermediate layer 5 and the substrate 3, as described below.

Since the intermediate layer 5 is excellent in adherence to the substrate 3 formed of ceramic including at least one selected from a group consisting of Al or Si, the adhesive layer 6 may be omitted. However, by interposing the adhesive layer 6, adherence of the intermediate layer 5 to the substrate 3 can be further improved.

The ceramic wiring substrate 1 comprising the above respective portions can be manufactured through steps of:
forming the substrate 3 by sintering;
forming the up-and-down conduction hole 2 in a predetermined position of the formed substrate 3 by penetrating in a thickness direction;
forming the adhesive layer 6 and the intermediate layer 5 sequentially on the inner surface of the up-and-down conduction hole 2;
filling in the up-and-down conduction hole 2 a paste including a powder of the high melting point metal to be sintered, thereby to form a porous structure body made of the high melting point metal; and
forming the up-and-down conduction body 4 by infiltrating the low-resistance metal into the formed porous structure body.

### <Substrate 3>

Various ceramics which include at least one selected from a group consisting of Al and Si and have a high heat spread property capable of complying with an increasing output of a semiconductor element can be used as ceramic forming the substrate 3.

Examples of such a ceramic include AlN, Al₂O₃, Si₃N₄, SiC and the like.

The substrate 3 formed of such ceramics is formed, for example, by sintering a plate body of a precursor to become the substrate 3 (ceramic green sheet), and further, by polishing its surface according to need. A condition and a temperature of sintering, a method of polishing, and the like can be the same in a prior art.

A surface roughness after polishing (an arithmetical mean deviation of a roughness profile, JIS B0601:2001) is preferably 0.01 µm or more, in particular 0.02 µm or more, and is preferably 1 µm or less, in particular 0.5 µm or less.

If the surface roughness is less than this range, there may be a problem that an effect of increasing adherence of a metallized layer by an anchor effect is insufficient, and if the surface roughness is more than this range, there may be a problem that forming a metallized layer having a uniform thickness is difficult.

Further, an thickness of the substrate 3 is preferably 0.1 mm or more, in particular 0.15 mm or more, and is preferably 1 mm or less, in particular 0.5 mm or less when a balance between a strength and a volume decrease of a semiconductor device is considered.

### <Up-and-down conduction hole 2>

A pore diameter of the up-and-down conduction hole 2 is preferably ϕ0.1 mm or more and is preferably ϕ0.3 mm or less, but is not specifically limited.

If the pore diameter is less than this range, there may be a problem that filling the paste to become the porous structure body in the formed up-and-down conduction hole 2 is difficult. On the other hand, if the pore diameter is more than this range, there may be a problem that the porous structure body formed by filling and sintering the paste and the up-and-down conduction body 4 formed by infiltrating the low-resistance metal into the porous structure body become prone to fall off from the substrate 3 in subsequent steps.

However, although it is required to adjust a viscosity and the like of the paste, the pore diameter may be less than ϕ0.1 mm depending on a condition such as wiring maneuverability, for example, and the pore diameter may be more than ϕ0.3 mm in order to improve electric characteristics, heat characteristics and the like, for example.

The up-and-down conduction hole 2 can be formed by various methods such as a method using a laser, a method using a microdrill and a method using a microblast, for example.

Among them, in the method using a laser or a microdrill, the up-and-down conduction hole 2 can be automatically formed in a predetermined formation position by programing the formation position of the up-and-down conduction hole 2 in a processing machine.

Further, in the method using a microblast, the up-and-down conduction hole 2 can be formed in a predetermined formation position by forming a resist pattern having a desired pattern through photolithography using a photoresist agent for blasting formed of a urethane resin and the like, for example, blowing blast from thereabove to selectively perforating a portion which is not covered by a resist, and thereafter, peeling and removing the resist.

Since the up-and-down conduction hole 2 is formed later on the substrate formed in a plate shape by previously being sintered as described above, a positional accuracy can be increased in comparison to a method where perforation is performed before sintering. Specifically, the positional accuracy can be made approximately ±50 µm or less.

### <Intermediate layer 5>

In a conventional method where a Cu film or the like for up-and-down conduction is formed by a wet plating method or the like on the inner surface of the up-and-down conduction hole 2, heating is required only in a range of 100 °C or less. Further, also in a method where a paste of Cu and Ag added with a glass component is filled and sintered to form an up-and-down conduction body, 900 °C or less is sufficient as its temperature.

However, as described above, in both of the step of forming the porous structure body by sintering the high melting point metal and the step of forming the up-and-down conduction body 4 by infiltrating the low-resistance metal in the porous structure body, heating at 900 °C or more is required, and Al or Si forming the substrate 3 are diffused into the up-and-down conduction body 4 under formation at such a high temperature.

Further,
- diffused Al or Si react at a high temperature of 900 °C or more to cause partial abnormal growth of Mo or W, thereby to produce an abnormally grown particle,
- the low-resistance metal infiltrated into the porous structure body is inhibited by the abnormally grown particle, and cannot uniformly go round in the porous structure body, thereby to cause a void or a crack, and
- Al or Si react with the low-resistance metal to produce gas, thereby to cause a void.

Further, on the contrary, the low-resistance metal in the up-and-down conduction body 4 may be diffused into the substrate 3, and react with Al or Si forming the substrate 3 to produce gas, thereby to cause a void. As a result, there is caused a problem that a favorable up-and-down conduction body 4 having a normal composite structure cannot be formed.

Contrary to these, as described above, according to the present invention, by providing the intermediate layer 5 which is formed on the inner surface of the up-and-down conduction hole 2 and is made of at least one selected from a group consisting of Mo, W, Co, Fe, Zr, Re, Os, Ta, Nb, Ir, Ru and Hf, Al or Si forming the substrate 3 can be prevented from diffusing into the up-and-down conduction body 4, or contrary, the low-resistance metal in the up-and-down conduction body 4 can be prevented from diffusing into the substrate 3. As a result, there can be formed a favorable up-and-down conduction body 4 having a normal composite structure without an abnormally grown particle, a void, a crack and the like.

Further, the intermediate layer 5 formed of the above various elements has favorable adherence to the substrate 3, and moreover, reacts favorably with the up-and-down conduction body 4 which is a composite body of the low-resistance metal and the high melting point metal. Accordingly, it can be possible that adherence between the substrate 3 and the up-and-down conduction body 4 is improved by interposing such an intermediate layer 5 thereby to prevent the up-and-down conduction body 4 from falling off from the substrate 3.

Additionally, it is preferable that the intermediate layer 5 is formed by Mo and/or W particularly excellent in a diffusion prevention effect among the above-described various elements.

The intermediate layer 5 can be formed by a general film formation method such as a physical vapor deposition method such as a sputtering method or a vacuum deposition method, a wet plating method, or a cold spray method.

For example, when film formation is performed by these film formation methods on surfaces 7, 8 on both sides of the substrate 3 provided with the up-and-down conduction hole 2, a film is formed not only on both the surfaces 7, 8, but a film formation material goes round into the inner surface of the up-and-down conduction hole 2 to form a film on the inner surface. Thereafter, when the film formed the surfaces 7, 8 of the substrate 3 except the inner surface of the up-and-down conduction hole 2 is removed by polishing and the like, the intermediate layer 5 is selectively formed only on the inner surface of the up-and-down conduction hole 2.

Additionally, depending on the thickness of the substrate 3, the pore diameter of the up-and-down conduction hole 2, and the like, even when film formation is performed only from one side of the substrate 3, there may be a case that a film can be formed on a generally entire surface of the inner surface of the up-and-down conduction hole 2. In this case, film formation only from one side may be sufficient.

It is preferable that a thickness of the intermediate layer 5 is 0.01 µm or more.

The inner surface of the up-and-down conduction hole 2 may have a case that a surface roughness thereof is rough and 1 µm or more even though it varies depending on a production method and the like thereof.

In this case, if the thickness of the intermediate layer 5 is less than 0.01 µm, there may be problems that a thickness of at least a portion of the intermediate layer 5 is extremely small whereby diffusion of Al or Si cannot be sufficiently prevented, and that a portion where the intermediate layer 5 is not at all formed is ceated.

If such portions are created, the function obtained by providing the intermediate layer 5 to prevent Al or Si forming the substrate 3 from diffusing into the up-and-down conduction body 4 and to prevent the low-resistance metal in the up-and-down conduction body 4 from diffusing into the substrate 3 is insufficient, and therefore, there may be a problem that an up-and-down conduction body 4 having a normal composite structure without an abnormally grown particle, a void, a crack and the like cannot be formed in a next step.

Further, there may be a problem that the effect due to the intermediate layer 5 to improve the adherence between the substrate 3 and the up-and-down conduction body 4 becomes insufficient whereby the up-and-down conduction body 4 is prone to fall off from the substrate 3.

Contrary to this, by making the thickness of the intermediate layer 5 0.01 µm or more, creation of the portion whose thickness is thin and the portion where the intermediate layer 5 is not formed is suppressed as much as possible, whereby the function of the intermediate layer 5 can be sufficiently expressed. Further, an up-and-down conduction body 4 having a normal composite structure where an abnormally grown particle, a void, a crack and the like are further effectively prevented can be formed in the next step, and the up-and-down conduction body 4 can be more reliably prevented from falling off from the substrate 3.

When further improving such an effect is considered, it is preferable that the thickness of the intermediate layer 5 is 0.1 µm or more, in particular 0.5 µm or more even within the above range.

Additionally, when considering the effect to prevent Al or Si forming the substrate 3 from diffusing into the up-and-down conduction body 4, and contrary, to prevent the low-resistance metal in the up-and-down conduction body 4 from diffusing into the substrate 3, it is ideal that the entire surface of the inner surface of the up-and-down conduction hole 2 is covered by the intermediate layer 5. However, depending on the above described surface roughness of the inner surface of the up-and-down conduction hole 2 and the like, there may be a case that an area where the intermediate layer 5 is partially not formed exists.

However, it is acceptable that an area where the intermediate layer 5 is not formed exists in a range where the effect obtained by providing the intermediate layer 5 is not lost, that is, in a range where an occurrence ratio of the void (including a crack) calculated by a method described below is 10 % or less.

Further, with respect to a grain boundary of the intermediate layer 5, there may be a case that the low-resistance metal forming the up-and-down conduction body 4 are diffused into the substrate 3 as a groundwork via the grain boundary by heating at a time of infiltration and the like.

When section observance is performed in this case, it is observed that the grain boundary of the intermediate layer 5 seems to have a configuration not covering the substrate 3. Further, there may be a case that the low-resistance metal diffused via such a grain boundary reacts with Al or Si forming the substrate 3 immediately under the grain boundary. However, since diffusion and reaction can be prevented by interposing the intermediate layer 5 except in the grain boundary, it has been found that there is not a practical problem.

An upper limit of the thickness of the intermediate layer 5 is not specifically limited.

When considering the effect to prevent Al or Si forming the substrate 3 from diffusing into the up-and-down conduction body 4, or contrary, to prevent the low-resistance metal in the up-and-down conduction body 4 from diffusing into the substrate 3, it is preferable that the intermediate layer 5 is as thick as possible.

However, it is preferable that the thickness of the intermediate layer 5 is 10 µm or less in the above-described physical vapor deposition method such as a sputtering method or a vacuum deposition method, or the wet plating method. A case where the thickness exceeds this range is not practical since an efficiency of film formation is significantly reduced.

On the other hand, the thickness of the intermediate layer 5 can be made large up to around 50 µm in the cold spray method and the like. However, in a case where the thickness exceeds this range, a pore diameter with which the up-and-down conduction body 4 can be formed becomes small particularly when the pore diameter of the up-and-down conduction hole 2 is small. Therefore, there may be problems that formation of the up-and-down conduction body 4 by the above-described steps is difficult and that a conductive property is lowered.

In view of the above, the thickness of the intermediate layer 5 can be appropriately set according to a difference of film formation methods, a pore diameter of the up-and-down conduction hole 2, and the like.

### <Adhesive layer 6>

As described above, the adhesive layer 6 can be formed by various materials having a function of improving adherence of the intermediate layer 5 to the substrate 3 formed of ceramic including at least one selected from a group consisting of Al and Si.

Examples of materials which are to become the adhesive layer 6 and have such a function can include Ti, Cr, NiCr, Ta, TaN, TiW and the like.

The adhesive layer 6 formed of these materials can be formed in a manner similar to the intermediate layer 5. When both of the adhesive layer 6 and the intermediate layer 5 are formed by the physical vapor deposition method such as a sputtering method or a vacuum deposition method, it is preferable that film formation is continuously performed in the same film formation device without exposing an inside of this device to the atmosphere. However, after the adhesive layer 6 is formed in the film formation device, the adhesive layer 6 may be taken out to the atmosphere and then the intermediate layer 5 may be formed in the same or a different film formation device.

A thickness of the adhesive layer 6 is not specifically limited but is preferably 0.01 µm or more. If the thickness is less than this range, there may be a problem that the effect obtained by providing the adhesive layer 6 to improve adherence of the intermediate layer 5 to the substrate is not sufficiently obtained.

Additionally, an upper limit of the thickness of the adhesive layer 6 can also be appropriately set according to a difference of the film formation methods, the pore diameter of the up-and-down conduction hole 2, and the like.

That is, it is preferable that the thickness of the adhesive layer 6 is 10 µm or less in the physical vapor deposition method such as a sputtering method or a vacuum deposition method, or the wet plating method. A case where the thickness exceeds this range is not practical since an efficiency of film formation is significantly reduced. Further, in case where a brittle material such as Ti is used as the adhesive layer 6, there may be a problem that a breakage is prone to occur in the adhesive layer 6 when the thickness exceeds the range.

Further, the thickness of the adhesive layer 6 can be made large up to around 50 µm in the cold spray method and the like.

However, in a case where the thickness exceeds this range, a pore diameter with which the up-and-down conduction body 4 can be formed becomes small particularly when the pore diameter of the up-and-down conduction hole 2 is small. Therefore, there may be problems that formation of the up-and-down conduction body 4 by the above-described steps is difficult and that a conductive property is lowered.

### <Up-and-down conduction body 4>

As described above, the up-and-down conduction body 4 is formed by first forming the porous structure body made of the at least one high melting point metal selected from the group consisting of W and Mo, and then infiltrating the at least one low-resistance metal selected from the group consisting of Cu, Ag and Au into the formed porous structure body. Moreover, the porous structure body may further include C.

### (Porous structure body)

In order to form the porous structure body, it is preferable that a paste including a powder of the high melting point metal, a resin binder, a solvent and the like is filled in the up-and-down conduction hole 2, is subjected to a binder elimination process (deresining process) according to need, and thereafter, is further sintered.

As a method for filling the paste, a known coating method such as screen printing, a dispenser, brush coating and spin roller coating can be employed.

An average particle diameter of the powder of the high melting point metal is preferably 1 µm or more and 10 µm or less.

In the case where the paste is filled and then is subjected to the binder elimination process according to need and is then sintered as described above, a sinterability is too high when the average particle diameter of the powder of the high melting point metal is less than the above range. Therefore, a contraction amount along with grain growth becomes larger at the time of sintering, whereby there may be a problem that the formed porous structure body is prone to fall off from the substrate.

Further, a filling density of the powder in the paste becomes lower because a bulk density of the powder becomes lower, and as a result of this, a powder density after filled in the up-and-down conduction hole 2 becomes lower. This is one more cause of that the porous structure body becomes prone to fall off from the substrate due to a larger contraction amount.

On the other hand, since a neck growth among the powder does not occur at the time of sintering and sintering is not fully progressed when the average particle diameter is more than the above range, there may be similarly a problem that the porous structure body becomes prone to fall off from the substrate.

Additionally, several types of powders of the high melting point metal having different particle diameters may be used together.

Examples of the resin binder may include one or two or more of an acrylic binder, ethylcellulose, cellulose nitrate, wax and the like.

Further, as the solvent, there can be used various solvents which can form a paste by favorably dissolving and dispersing the resin binder and favorably dispersing the powder of the high melting point metal.

Examples of such a solvent may include at least one of Butyl carbitol, terpineol and the like.

With respect to a blending ratio of the resin binder and the solvent, it is usually preferable that the resin binder is 1 part by mass or more and 3 parts by mass or less and the solvent is 3 parts by mass or more and 15 parts by mass or less per 100 parts by mass of the powder of the high melting point metal. However, considering a filling property of the paste into the up-and-down conduction hole 2, a carbon residue amount after the binder elimination process, and the like, it is possible that the blending ratio of both the components is set to a range other than this.

In the next binder elimination process, in order to sufficiently remove the resin binder and the solvent in the paste filled in the up-and-down conduction hole 2, it is preferable that heating is performed to a temperature of 300 °C or more and 1000 °C or less in an inoxidizing atmosphere such as nitrogen, hydrogen and vacuum, for example.

After the binder elimination process, it is preferable that a carbon residue amount before sintering is 300 ppm or less.

In case where the carbon residue amount is more than this range, there may be a problem that an abnormally grown particle, a void, a crack and the like are created when the up-and-down conduction body is formed by infiltrating the low-resistance metal after sintering the high melting point metal.

Since the paste filled in the up-and-down conduction hole 2 has a small contact surface to the air, the resin binder and the solvent are prone to be not readily removed at the time of the binder elimination process. However, the carbon residue amount can be made within the above range by optimizing the types and the blending ratio of the resin binder and the solvent, or conditions of the binder elimination process and the like.

The high melting point metal remained in the up-and-down conduction hole 2 after the binder elimination process is sintered in an inoxidizing atmosphere such as nitrogen, hydrogen, vacuum and the like. Generally, it is preferable that a sintering temperature is 600 °C or more and 1300 °C or less and that a sintering time is 0.5 hour or more and 20 hours or less.

By the sintering, neck growth occurs between powders of the high melting point metal, and at the same time, neck growth occurs between the powder and the intermediate layer 5.

When the intermediate layer 5 does not exist, the high melting point metal and the ceramic forming the inner surface of the up-and-down conduction hole 2 of the substrate 3 do not cause neck growth, and therefore, falling off of the up-and-down conduction body 4 occurs as described above. However, by forming the intermediate layer 5, neck growth occurs between the intermediate layer 5 and the high melting point metal as described above, whereby falling off can be prevented.

When the powder of the high melting point metal is sintered, the resin binder and the solvent are first removed by the binder elimination process, and moreover, contraction is further caused by sintering. Therefore, a countless number of pores are created among the sintered powder to form the porous structure body.

Additionally, when a distribution of the pores is unbalanced, a distribution of the low-resistance metal infiltrated into these pores becomes unbalanced. Accordingly, it is preferable that the particle diameter of the powder, the types and the blending ratio of the resin binder and the solvent, and moreover, a method for filling the paste, and the like are selected such that the pores in the porous structure body are as uniform as possible.

Further, as a state after the sintering, it is preferable that the porous structure body is in a state where neck growth occurs over an entirety of the up-and-down conduction hole 2. To this end, it is after all preferable that the particle diameter of the powder, the types and the blending ratio of the resin binder and the solvent, and moreover, a method for filling the paste, and the like are selected.

Through forming the porous structure body which is to become a frame of the up-and-down conduction body 4 by the at least one of the high melting point metal selected from the group consisting of W and Mo whose thermal expansion coefficients are close to ceramic, there can be removed an influence of the low-resistance metal having a high thermal expansion coefficient and filling the pores of the porous structure body in a next step, whereby a thermal expansion coefficient of the up-and-down conduction body 4 can be made closer to that of the substrate 3 formed of ceramic.

As a result, reliability of mounting of the semiconductor element can be significantly improved by preventing that a local stress is applied to the metallized layer or the solder layer which are formed on the surfaces 7, 8 of the substrate 3 to form a crack, and that a large thermal stress is applied to the substrate itself and the mounted semiconductor element.

### (Infiltration of low-resistance metal)

For example, the substrate 3 where the porous structure body is formed in the up-and-down conduction hole 2 is heated to a melting temperature of the low-resistance metal or more in an inoxidizing atmosphere such as nitrogen, hydrogen, vacuum and the like with the substrate 3 sandwiched from above and below by plates formed of the low-resistance metal to infiltrate or with such a plate superposed on one surface of the substrate 3.

Consequently, the melted low-resistance metal wets and expands by a capillary phenomenon in a countless number of the pores in the porous structure body, and as a result, the low-resistance metal is infiltrated into the porous structure body thereby to form the up-and-down conduction body 4.

Generally, it is preferable that an infiltrating temperature is 900 °C or more and 1500 °C or less and that an infiltrating time is 0.5 hour or more and 10 hours or less.

During such an infiltrating step, in a conventional system where the intermediate layer 5 is not provided, Al or Si are diffused from the substrate 3, or contrary, the low-resistance metal in the up-and-down conduction body 4 is diffused into the substrate, whereby various problems such as those described above occur. However, according to the present invention, these problems can be prevented from occurring by providing the intermediate layer 5.

Further, as also described above, in order to significantly improve reliability of mounting of the semiconductor element by preventing that a local stress is applied to the metallized layer or the solder layer which are formed on the surfaces 7, 8 of the substrate 3 to form a crack, and that a large thermal stress is applied to the substrate itself and the mounted semiconductor element, it is preferable that the thermal expansion coefficient of the up-and-down conduction body 4 formed by infiltrating the low-resistance metal into the porous structure body formed of the high melting point metal is made as close as possible to that of the substrate 3 formed of ceramic.

The thermal expansion coefficient of the up-and-down conduction body 4 is determined by an existence ratio between the high melting point metal forming the porous structure body and the low-resistance metal infiltrated into the porous structure body.

In the following, an existence ratio of the low-resistance metal in the up-and-down conduction body 4 is represented by a percentage of a sectional area of the low-resistance metal occupying an entire sectional area calculated by the following method.

That is, the formed up-and-down conduction body 4 is subjected to section processing by cross-section polish (CP) processing where dry etching is performed by Ar plasma, this section is subjected to sectional observation by a scanning electron microscope (SEM) at 250-fold magnification at a field of view of 350 µm x 500 µm with a number of views with which all of the up-and-down conduction body 4 can be observed, thereby to measure a sectional area. Then, the percentage of the sectional area of the low-resistance metal occupying the entire sectional area is calculated to be considered as the existence ratio of the low-resistance metal.

It is preferable that the existence ratio of the low-resistance metal is 3 % or more and 88 % or less.

When the existence ratio of the low-resistance metal is less than this range, there may be a problem that the pores formed in the porous structure body cannot be completely filled by the low-resistance metal whereby a void is remained. Further, when the range is exceeded, there may be a problem that the thermal expansion coefficient of the up-and-down conduction body 4 becomes larger than 15×10⁻⁶/K and a thermal expansion difference to the substrate 3 formed of ceramic becomes larger whereby the above-described problems are prone to occur.

Contrary to this, when the existence ratio of the low-resistance metal is made larger even within the above range, the up-and-down conduction body 4 has a lower resistance, and on the contrary, the existence ratio of the low-resistance metal is made lower, its thermal expansion coefficient can be made closer to that of the substrate 3 formed of ceramic.

Additionally, the existence ratio of the low-resistance metal is further preferably 10 % or more and further preferably 70 % or less even within the above range.

It is sometimes required that the up-and-down conduction body 4 has a high thermal conductivity. In this case, it is often required that the thermal conductivity is 180 W/mK or more. In order to achieve this, it is preferable that the existence ratio of the low-resistance metal is in the above range or more.

Further, a diameter of the up-and-down conduction body 4 is usually approximately 0.3 mm at the largest. However, in a case of an application where a thermal conductivity is required as described above, there may be a case that the diameter is made 0.5 mm or more in order to ensure a heat radiation path. In this case, the thermal expansion coefficient of the up-and-down conduction body 4 is required to be made further closer to that of the substrate 3 formed of ceramic.

However, when the existence ratio of the low-resistance metal is more than the above range, there may be a problem that the thermal expansion coefficient is higher than 12×10⁻⁶/K whereby a probability of occurrence of the above problem becomes higher.

When the intermediate layer 5 does not exist or film formation is not performed under an appropriate condition, the high melting point metal reacts with Al or Si diffused from the substrate whereby an abnormally grown particle is created by abnormal growth of the high melting point metal, as described above.

When a particle diameter of the abnormally grown particle is 40 µm or more, there may be a problem that the low-resistance metal which infiltrates into the porous structure body is hindered by the abnormally grown particle and cannot go uniformly round into the porous structure body whereby a void or a crack are created.

In the following, an occurrence ratio of the void (including a crack) is represented by a percentage of a sectional area of the void occupying an entire sectional area calculated in a manner similar to the existence ratio of the low-resistance metal.

That is, the formed up-and-down conduction body 4 is subjected to section processing by cross-section polish (CP) processing where dry etching is performed by Ar plasma, this section is subjected to sectional observation by a scanning electron microscope (SEM) at 250-fold magnification at a field of view of 350 µm x 500 µm with a number of views with which all of the up-and-down conduction body 4 can be observed, thereby to measure a sectional area. Then, the percentage of the sectional area of the void occupying the entire sectional area is calculated to be considered as the occurrence ratio of the void.

It is preferable that this occurrence ratio of the void is 10 % or less. When the occurrence ratio of the void is more than this range, the infiltrated low-resistance metal does not go sufficiently round into the porous structure body, and a void or a crack are created in the up-and-down conduction body 4. Further, there may be a problem that when the metallized layer is formed on the surfaces 7, 8 of the substrate 3 including the up-and-down conduction body 4 as described below, there is caused a problem that the metallized layer has a weaker adhesion strength to peel off due to gas generation from the void or the crack, or that a crack is created in the metallized layer or the solder layer above it even if the metallized layer does not peel off.

Additionally, it is preferable the occurrence ratio of the void is 5 % or less even within the above range. In a case where the occurrence ratio of the void is more than this range, there may be a problem that a crack is created in the metallized layer immediately above the up-and-down conduction body 4 and the solder layer above it because of being strongly influenced by the above-described void or crack when a thickness of the metallized layer is less than 0.5 µm.

Additionally, a void may be created in the up-and-down conduction body 4 or may be created in an interface between the up-and-down conduction body 4 and the substrate 3. Here, an area ratio of the void (clearance) created in the interface is included in the occurrence ratio of the void.

It goes without saying that a lower limit of the occurrence ratio of the void is 0%. It is ideal that a void does not exist at all.

The above-described existence ratio of the low-resistance metal can be set within the above range by adjusting the viscosity of the paste which is to become the porous structure body, the amount of the resin binder, and the like described above.

That is, when a ratio of the high melting point metal included in the paste is reduced by reducing the viscosity of the paste or by increasing the amount of the resin binder, the existence ratio of the low-resistance metal included in the up-and-down conduction body 4 formed through the above-described steps using this paste can be increased.

### <Semiconductor device>

Fig. 2 is a sectional view showing an enlarged portion of a semiconductor device where a semiconductor element is mounted on the ceramic wiring substrate of the example in Fig. 1.

Referring to Fig. 2, a semiconductor device 9 of this example is configured by forming metallized layers 10, 11 on the surfaces 7, 8 including the up-and-down conduction body 4 on up and down sides of the substrate 3 in the drawing of the ceramic wiring substrate 1 and by mounting a semiconductor element 13 on the upper metallized layer 10 further via a solder layer 12.

### (Metallized layers 10, 11)

The metallized layers 10, 11 are formed on the surfaces 7, 8 of the substrate 3 where the up-and-down conduction body 4 is formed as described above and which is further polished to have the above-described predetermined surface roughness Ra according to need.

While the metallized layers 10, 11 may be formed in a single-layer structure having only a conductive layer described below, it is usually preferable that the metallized layers 10, 11 are formed in an at least two-layer structure having an adhesive layer for ensuring adherence to the substrate 3 and an electrode layer for external connection. Further, a diffusion prevention layer may be interposed between both of these layers.

The adhesive layer is formed by, for example, Ti, Cr, NiCr, Ta, TiW, a compound of these, and the like to have a thickness of approximately 0.05 µm or more and 1.0 µm or less. Examples of a formation method include the physical vapor deposition method such as a sputtering method or a vacuum deposition method.

Further, the diffusion prevention layer is formed of, for example, Pt, Pd, Cu, Ni, Mo and NiCr.

Further, the conductive layer is formed of, for example, Ag, Al and Au to have a thickness of approximately 0.1 µm or more and 10 µm or less. Examples of a formation method include the physical vapor deposition method such as a sputtering method or a vacuum deposition method, and the wet plating method.

Both of the single-layer and laminated metallized layers 10, 11 can be provided with a fine pattern by photolithography.

Further, the metallized layers 10, 11 can also be formed by a thick film process (Au, Cu and the like). Further, a pattern formed ty the thick film process can be further subjected to pattern formation by polishing and chemical etching according to need, and film formation can also be performed on the pattern by Ni and Ni/Au plating.

A resistance film of NiCr, TaN and the like may be formed on the metallized layers 10, 11 formed by each of the above-described methods and in a vicinity thereof according to need.

Additionally, the metallized layers 10, 11 may be provided with a solid pattern without performing the above-described patter formation depending on a structure and the like of the semiconductor device 9.

Further, the solder layer 12 of AuSn and the like is formed by pattern formation in a predetermined position of the upper metallized layer 10 in the case of the example of the drawing.

Usually, a plurality of areas which are to become the semiconductor device 9 are set on one substrate 3, are provided with the metallized layers 10, 11, are then cut per individual area by a well-known method such as dicing and laser, and thereafter, are mounted with the semiconductor element 13 via Pb free solder such as AuSn solder in respective predetermined positions. Specifically, it is general that a solder foil whose thickness is 10 µm or more and 100 µm or less is interposed between the semiconductor element 13 and the metallized layer 10 to make solder joint.

However, the solder layer 12 whose thickness is 1 µm or more and 20 µm or less may be previously formed by pattern formation with a good positional accuracy on the metallized layer 10 of the substrate 3 before being cut by the wet plating method or the physical vapor deposition method such as a vacuum deposition method.

When a thickness of such a solder layer 12 is 8 µm or less, it is preferable that a proportion of the low-resistance metal in the up-and-down conduction body 4 is 50 % or less.

When the thickness of the solder layer 12 is thin and 8 µm or less, and moreover, the proportion of the low-resistance metal has a high density of 50 % or more, a local stress applied to the solder layer 12 by expansion and contraction of the up-and-down conduction body 4 is relatively larger, and therefore, there may be a high risk that the solder layer 12 has a crack. Contrary to this, if the proportion of the low-resistance metal is made 50 % or less when the thickness of the solder layer 12 is 8 µm or less, the expansion and contraction of the up-and-down conduction body 4 can be suppressed to more reliably prevent that a crack is created in the solder layer 12.

Additionally, the substrate 3 may be cut along areas after the semiconductor element 13 is mounted.

### (Semiconductor element 13)

The semiconductor element 13 is not specifically limited, and various semiconductor element formed of Si, GaAs, InP, GaN, SiC and the like can be mounted. A size of the semiconductor element is also not specifically limited.

### Examples

### <Example 1>

### (Formation of up-and-down conduction hole 2)

A substrate 3 having a size of 100 mm x 100mm x 0.5mm, formed of AlN and polished to have a surface roughness of 0.5 µm was provided with 3000 up-and-down conduction holes 2 of ϕ0.5 mm using a YAG laser. A positional accuracy of the formed up-and-down conduction holes 2 were ±20 µm when measured by a toolmaker's microscope.

### (Formation of adhesive layer 6 and intermediate layer 5)

The substrate 3 provided with the up-and-down conduction holes 2 was subjected to ultrasonic cleaning by isopropanol (IPA), was blown by air to scatter IPA, and thereafter, was heated at 100 °C for 10 minutes in an oven to be dried.

Surfaces 7, 8 on both sides of the substrate 3 and inner surfaces of the up-and-down conduction holes 2 were subjected to film formation of a Ti film having a thickness of 0.1 µm as an adhesive layer 6 and a W film having a thickness of 1.0 µm as an intermediate layer 5 in this order by a sputtering method.

The film formation was performed according to an ordinary method after the substrate 3 was heated by halogen heater at 200 °C for 5 minutes in a sputtering device under an atmosphere having an ultimate vacuum of 1×10⁻⁴ Pa, and then, was subjected to dry cleaning by Ar plasma.

Then, films formed on the surfaces 7, 8 of the substrate 3 after the film formation except the inner surface of the up-and-down conduction hole 2 were removed by polishing and the like to achieve a state where the inner surface of the up-and-down conduction hole 2 was selectively provided with the adhesive layer 6 and the intermediate layer 5.

### (Formation of up-and-down conduction body 4)

A paste which included a powder of W as a high melting point metal and was to become a porous structure body was filled in the up-and-down conduction hole 2.

As the paste, one produced by mixing and dispersing 2 parts by mass of an acrylic binder as a resin binder and 5 parts by mass of Butyl carbitol as a solvent per 100 parts by mass of a W powder having an average particle diameter of 5 µm was used. This paste was filled in the up-and-down conduction hole 2 using a screen printer.

A binder elimination process was performed by heating at 600 °C for 3 hours in a nitrogen atmosphere, and then, the powder of W was sintered by heating at 1000 °C for 1 hour in a hydrogen atmosphere, thereby to form the porous structure body.

The AlN substrate in a state of being sandwiched from up and down by two Cu plates of an amount required for infiltration was heated at 1200 °C for 0.5 hour in a hydrogen atmosphere to infiltrate Cu as a low-resistance metal into the porous structure body in the up-and-down conduction hole 2, thereby to form an up-and-down conduction body 4 having a composite structure of Cu and W.

Both the surfaces 7, 8 of the substrate 3 were polished to have a surface roughness of 0.5 µm, thereby complete a ceramic wiring substrate 1.

### (Formation of metallized layers 10, 11 and pattern formation)

Metallized layers 10, 11 configuring a circuit pattern were formed by the following method on both the surfaces 7, 8 of the substrate 3 of the ceramic wiring substrate 1.

The substrate 3 was subjected to ultrasonic cleaning by isopropanol (IPA), was blown by air to scatter IPA, and thereafter, was heated at 100 °C for 10 minutes in an oven to be dried.

Both the surfaces 7, 8 of the substrate 3 were provided with 0.05 µm of a Ti film as an adhesive layer, then 0.2 µm of a Pt film as a diffusion prevention layer, and further 0.2 µm of an Au film as a conductive layer in this order by a sputtering method, thereby to form the metallized layers 10, 11 of a three-layer structure.

The film formation was performed according to an ordinary method after the substrate 3 was heated by halogen heater at 200 °C for 5 minutes in a sputtering device under an atmosphere having an ultimate vacuum of 1×10⁻⁴ Pa, and then, was subjected to dry cleaning by Ar plasma.

Photoresist was applied to the metallized layers 10, 11 per one surface by a spin coating method. A resist thickness of each surface was set to around 5 µm.

A pattern formed on a photomask was exposed and transferred to the resist using exposure equipment, thereafter, was immersed in developer kept at 30 °C for 5 minutes, and then was immersed in a rinsing solution for 5 minutes and further in pure water for 10 minutes to print the pattern on the resist.

Further, after the metallized layers 10, 11 on a portion other than a portion covered by the resist were removed by Ar plasma using a dry etching device, were immersed in a resist peeling solution kept at 80 °C for 3 minutes, and then were immersed in a rinsing solution for 5 minutes and in pure water for 10 minutes to remove the resist, whereby a pattern was formed on the metallized layers 10, 11.

### (Sectional observation 1)

When the up-and-down conduction body 4 of the produced ceramic wiring substrate 1 and the metallized layers 10, 11 immediately thereabove were subjected to section processing by cross-section polish (CP) processing where dry etching was performed by Ar plasma, and a section of up-and-down conduction body 4 among them was subjected to sectional observation by a scanning electron microscope (SEM) at 250-fold magnification at a field of view of 350 µm x 500 µm with respect to 10 up-and-down conduction bodies with two views per up-and-down conduction body 4, a crack, segregation of Cu or W (resulting from an abnormally grown particle of W) and the like were not observed. Further, a clearance was not observed in the interface between the up-and-down conduction body 4 and the substrate 3. Further, an occurrence ratio of the void occupied in an entire sectional area was 1 %, and an existence ratio of Cu was 30 %.

A thermal expansion coefficient of the up-and-down conduction body 4 which had the composite structure of Cu and W and whose existence ratio of Cu was 30 % was approximately 7 to 8×10⁻⁶/K and was close to a thermal expansion coefficient of AlN (4.5×10⁻⁶/K) which was a substrate material. Therefore, it was confirmed that a crack was not prone to be created in the metallized layers 10, 11 or the solder layer 12 even when subjected to a high temperature in a joint process of the semiconductor element and so forth unlike in a case where Cu only (thermal expansion coefficient: 17×10⁻⁶/K) is used as an up-and-down conduction body 4.

With respect to this, after an Si element having a size of 1 mm x 1 mm x 0.3 mm was actually jointed to the metallized layer 10 via an AuSn solder foil having a thickness of 30 µm by heating at 300 °C for 10 minutes, an AuSn solder layer 12 formed of this solder foil was subjected to section processing in a similar manner, and this section was subjected to sectional observation by a scanning electron microscope (SEM) at 1000-fold magnification at a field of view of 90 µm x 130 µm over eight views, thereby to evaluate presence or absence of a crack. An evaluation standard was as follows.
Excellent: A crack was not observed at all according to the above-described measuring method.
Good: While cracks were observed, respective lengths of the cracks were all 3 µm or less and a total crack length was 0.1 mm or less, and it was considered that they do not influence a junction characteristic and electric and thermal properties.
Normal: The longest crack length was more than 3 µm and 5 µm or less and a total crack length was 0.1 mm or less, and it was considered that they do hardly influence a junction characteristic and electric and thermal properties.
Bad: The longest crack length was more than 5 µm or a total crack length was more than 0.1 mm, and it was considered there might be a problem that they influence a junction characteristic and electric and thermal properties.

### Example 1 was excellent.

Incidentally, a crack in the AuSn solder layer 12 is created due to not only a thermal expansion difference between the up-and-down conduction body 4 and the substrate 3 but also a void in the up-and-down conduction body 4 as described above or a clearance in the interface between the up-and-down conduction body 4 and the substrate 3. A case that a void occurrence ratio is more than 10 % shows that the infiltrated low-resistance metal does not sufficiently go round into the porous structure body, and there may be a problem that a crack is created not only in the up-and-down conduction body 4 but also in the metallized layers 10, 11 formed thereon and the AuSn solder layer 12 formed on the metallized layer 10.

### (Section observation 2)

Therefore, the sections of the metallized layers 10, 11 which were subjected to section processing in section observation 1 were subjected to sectional observation by a scanning electron microscope (SEM) at 5000-fold magnification at a field of view of 18 µm × 25 µm at one view per one up-and-down conduction body 4 over 100 views with respect to 100 up-and-down conduction bodies 4, thereby to evaluate presence or absence of a crack of the metallized layers 10, 11. An evaluation standard was as follows.
Excellent: A crack was not observed at all in the metallized layers 10, 11 according to the above-described measuring method.
Good: While a crack was observed, a length of the crack was 0.1 µm or less, and it was considered that the crack does not influence a junction characteristic and electric and thermal properties.
Normal: A length of a crack was more than 0.1 µm and 0.2 µm or less, and it was considered that the crack does hardly influence a junction characteristic and electric and thermal properties.
Bad: A length of a crack was more than 0.2 µm, and it was considered there might be a problem that the crack influences a junction characteristic and electric and thermal properties.

### Example 1 was excellent.

### <Comparative Example 1>

A ceramic wiring substrate 1 was completed in a manner similar to Example 1 except that an adhesive layer 6 and an intermediate layer 5 were both not formed on an inner surface of an up-and-down conduction hole 2, and metallized layers 10, 11 were formed and these metallized layers 10, 11 were subjected to pattern formation.

When above section observations 1, 2 were performed, an occurrence ratio of the void was 35 % and an existence ratio of Cu was 30 %. Further, a crack evaluation of the AuSn solder layer 12 with the element mounted was bad, a crack evaluation of the metallized layers 10, 11 was bad. In particular, it was observed that not only a crack but also a peel was created in the metallized layers 10, 11.

### <Example 2>

A ceramic wiring substrate 1 was completed in a manner similar to Example 1 except that a thickness of a W film as an intermediate layer 5 was made 0.01 µm (Example 2-1), 0.1 µm (Example 2-2), 0.3 µm (Example 2-3), 0.5 µm (Example 2-4), 3.0 µm (Example 2-5) and 10.0 µm (Example 2-6), and metallized layers 10, 11 were formed and these metallized layers 10, 11 were subjected to pattern formation, then section observations 1, 2 were performed. Results are shown along with the results of Example 1 and Comparative Example 1 in Table 1.

**[Table 1]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 2-1 | Ti | 0.1 | W | 0.01 | 10 | Cu-W | 30 | Good | Good |
| Example 2-2 | Ti | 0.1 | W | 0.1 | 5 | Cu-W | 30 | Excellent | Excellent |
| Example 2-3 | Ti | 0.1 | W | 0.3 | 4 | Cu-W | 30 | Excellent | Excellent |
| Example 2-4 | Ti | 0.1 | W | 0.5 | 1 | Cu-W | 30 | Excellent | Excellent |
| Example 1 | Ti | 0.1 | W | 1.0 | 1 | Cu-W | 30 | Excellent | Excellent |
| Example 2-5 | Ti | 0.1 | W | 3.0 | 1 | Cu-W | 30 | Excellent | Excellent |
| Example 2-6 | Ti | 0.1 | W | 10.0 | 1 | Cu-W | 30 | Excellent | Excellent |
| Comparative Example 1 | - | - | - | - | 35 | Cu-W | 30 | Bad | Bad |

According to the results of Example 1, Examples 2-1 to 2-6 and Comparative Example 1 in Table 1, it was found that by forming the W film as the intermediate layer 5 on an inner surface of an up-and-down conduction hole 2, diffusion of Al from a ceramic substrate 3 and the occurrence ratio of the void resulted therefrom in an up-and-down conduction body 4 can be suppressed at 10 % or less, whereby creation of a crack in the metallized layers 10, 11 formed on surfaces 7, 8 of the substrate 3, an AuSn solder layer 12 formed on the metallized layer 10, and the like can be suppressed.

Further, according to the results of Example 1 and Examples 2-1 to 2-6, when improving such an effect was considered, it was found that the thickness of the W film as the intermediate layer 5 is preferably 0.01 µm or more, in particular 0.1 µm or more, and further, it was found that creation of a void can be suppressed by setting the thickness of the W film as the intermediate layer 5 to 0.5 µm or more.

### <Example 3>

A ceramic wiring substrate 1 was completed in a manner similar to Example 1 except that a Mo film having a thickness of 0.01 µm (Example 3-1), 0.1 µm (Example 3-2), 0.3 µm (Example 3-3), 0.5 µm (Example 3-4), 1.0 µm (Example 3-5), 3.0 µm (Example 3-6) or 10.0 µm (Example 3-7) was formed as an intermediate layer 5, and metallized layers 10, 11 were formed and these metallized layers 10, 11 were subjected to pattern formation, then section observations 1, 2 were performed. Results are shown along with the results of Comparative Example 1 in Table 2.

**[Table 2]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 3-1 | Ti | 0.1 | Mo | 0.01 | 9 | Cu-W | 30 | Good | Good |
| Example 3-2 | Ti | 0.1 | Mo | 0.1 | 4 | Cu-W | 30 | Excellent | Excellent |
| Example 3-3 | Ti | 0.1 | Mo | 0.3 | 3 | Cu-W | 30 | Excellent | Excellent |
| Example 3-4 | Ti | 0.1 | Mo | 0.5 | 1 | Cu-W | 30 | Excellent | Excellent |
| Example 3-5 | Ti | 0.1 | Mo | 1.0 | 1 | Cu-W | 30 | Excellent | Excellent |
| Example 3-6 | Ti | 0.1 | Mo | 3.0 | 1 | Cu-W | 30 | Excellent | Excellent |
| Example 3-7 | Ti | 0.1 | Mo | 10.0 | 1 | Cu-W | 30 | Excellent | Excellent |
| Comparative Example 1 | - | - | - | - | 35 | Cu-W | 30 | Bad | Bad |

According to the results of Examples 3-1 to 3-7 and Comparative Example 1 in Table 2, it was found that also when the Mo film was formed as the intermediate layer 5, an effect similar to the W film in Examples 1 and 2 can be obtained.

That is, it was found that by forming the Mo film as the intermediate layer 5 on an inner surface of an up-and-down conduction hole 2, diffusion of Al from a ceramic substrate 3 and the occurrence ratio of the void resulted therefrom in an up-and-down conduction body 4 can be suppressed at 10 % or less, whereby creation of a crack in the metallized layers 10, 11 formed on surfaces 7, 8 of the substrate 3, an AuSn solder layer 12 formed on the metallized layer 10, and the like can be suppressed.

Further, when improving such an effect was considered, it was found that the thickness of the Mo film as the intermediate layer 5 is preferably 0.01 µm or more, in particular 0.1 µm or more, and further, it was found that creation of a void can be suppressed by setting the thickness of the Mo film as the intermediate layer 5 to 0.5 µm or more.

### <Example 4-1>

A ceramic wiring substrate 1 was completed in a manner similar to Example 1 except that a W film as an intermediate layer 5 was formed directly on an inner surface of an up-and-down conduction hole 2 without forming an adhesive layer 6, and metallized layers 10, 11 were formed and these metallized layers 10, 11 were subjected to pattern formation, then section observations 1, 2 were performed.

### <Examples 4-2 to 4-5>

A ceramic wiring substrate 1 was completed in a manner similar to Example 1 except that a thickness of a Ti film as an adhesive layer 6 was made 0.01 µm (Example 4-2), 0.05 µm (Example 4-3), 1.0 µm (Example 4-4) or 10.0 µm (Example 4-5), and metallized layers 10, 11 were formed and these metallized layers 10, 11 were subjected to pattern formation, then section observations 1, 2 were performed. Results are shown along with the results of Example 1 in Table 3.

**[Table 3]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 4-1 | Ti | - | W | 1.0 | 10 | Cu-W | 30 | Good | Good |
| Example 4-2 | Ti | 0.01 | W | 1.0 | 5 | Cu-W | 30 | Good | Good |
| Example 4-3 | Ti | 0.05 | W | 1.0 | 3 | Cu-W | 30 | Excellent | Excellent |
| Example 1 | Ti | 0.1 | W | 1.0 | 1 | Cu-W | 30 | Excellent | Excellent |
| Example 4-4 | Ti | 1.0 | W | 1.0 | 1 | Cu-W | 30 | Excellent | Excellent |
| Example 4-5 | Ti | 10.0 | W | 1.0 | 1 | Cu-W | 30 | Excellent | Excellent |

According to the results of Example 1 and Example 4-1 in Table 3, it was found that it is preferably to form the Ti film as the adhesive layer 6 under the intermediate layer 5 in order to improve the effect of suppressing creation of a crack in the metallized layers 10, 11 formed on surfaces 7, 8 of a substrate 3, an AuSn solder layer 12 formed on the metallized layer 10, and the like by reliably suppressing creation of a void.

Further, according to the results of Example 1 and Examples 4-2 to 4-5, when improving such an effect was considered, it was found that the thickness of the Ti film as the adhesive layer 6 is preferably 0.01 µm or more, in particular 0.05 µm or more.

### <Example 5>

A ceramic wiring substrate 1 was completed in a manner similar to Example 1 except that a Cr film (Example 5-1) and an NiCr film (Example 5-2) respectively having a thickness of 0.1 µm were formed as an adhesive layer 6, and metallized layers 10, 11 were formed and these metallized layers 10, 11 were subjected to pattern formation, then section observations 1, 2 were performed. Results are shown along with the results of Example 1 in Table 4.

**[Table 4]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 1 | Ti | 0.1 | W | 1.0 | 1 | Cu-W | 30 | Excellent | Excellent |
| Example 5-1 | Cr | 0.1 | W | 1.0 | 1 | Cu-W | 30 | Excellent | Excellent |
| Example 5-2 | NiCr | 0.1 | W | 1.0 | 1 | Cu-W | 30 | Excellent | Excellent |

According to the results in Table 4, it was found that not only Ti but also Cr and Nicr can function in the same way as the adhesive layer 6.

### <Example 6>

A ceramic wiring substrate 1 comprising an up-and-down conduction body 4 having a composite structure of Cu and W where an existence ratio of Cu was 3 % (Example 6-1), 10 % (Example 6-2), 20 % (Example 6-3), 70 % (Example 6-4) and 88 % (Example 6-5) was completed in a manner similar to Example 1 except that a viscosity of a paste which was to become a porous structure body and includes a W powder, an amount of a resin binder of the paste, and the like were adjusted, and metallized layers 10, 11 were formed and these metallized layers 10, 11 were subjected to pattern formation, then section observations 1, 2 were performed.

### <Comparative Example 3>

A ceramic wiring substrate 1 was completed in a manner similar to Example 1 except that Cu was filled into an up-and-down conduction hole 2 sequentially provided with an adhesive layer 6 and an intermediate layer 5 by a wet plating thereby to form an up-and-down conduction body 4 of Cu alone, and metallized layers 10, 11 were formed and these metallized layers 10, 11 were subjected to pattern formation, then section observations 1, 2 were performed.

Results of the above are shown along with the results of Example 1 in Table 5.

**[Table 5]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 6-1 | Ti | 0.1 | W | 1.0 | 4 | Cu-W | 3 | Excellent | Excellent |
| Example 6-2 | Ti | 0.1 | W | 1.0 | 1 | Cu-W | 10 | Excellent | Excellent |
| Example 6-3 | Ti | 0.1 | W | 1.0 | 1 | Cu-W | 20 | Excellent | Excellent |
| Example 1 | Ti | 0.1 | W | 1.0 | 1 | Cu-W | 30 | Excellent | Excellent |
| Example 6-4 | Ti | 0.1 | W | 1.0 | 1 | Cu-W | 70 | Excellent | Excellent |
| Example 6-5 | Ti | 0.1 | W | 1.0 | 1 | Cu-W | 88 | Good | Good |
| Comparative Example 3 | Ti | 0.1 | W | 1.0 | 0 | Cu | 100 | Bad | Bad |

According to the results of Example 1 and Comparative Example 3 in Table 5, it was found that by making a thermal expansion coefficient of the up-and-down conduction body 4 closer to that of the substrate 3 through providing the up-and-down conduction body 4 with the composite structure of Cu and W, creation of a crack in the metallized layers 10, 11 formed on surfaces 7, 8 of the substrate 3, an AuSn solder layer 12 formed on the metallized layer 10, and the like can be suppressed.

Further, according to the results of Example 1 and Examples 6-1 to 6-5, when improving such an effect while suppressing creation of a void was considered, it was found that the existence ratio of Cu in the up-and-down conduction body 4 having the composite structure of Cu and W is set to preferably 3 % or more, particularly preferably 10 % or more, and is set to preferably 88 % or less, particularly preferably 70 % or less.

### <Example 7>

A ceramic wiring substrate 1 comprising an up-and-down conduction body 4 having a composite structure of Cu and Mo where an existence ratio of Cu was 3 % (Example 7-1), 10 % (Example 7-2), 20 % (Example 7-3), 30 % (Example 7-4), 70 % (Example 7-5) and 88 % (Example 7-6) was completed in a manner similar to Example 1 except that a porous structure body was formed of Mo, and that a viscosity of a paste including a powder of Mo, an amount of a resin binder of the paste, and the like were adjusted, and metallized layers 10, 11 were formed and these metallized layers 10, 11 were subjected to pattern formation, then section observations 1, 2 were performed. Results are shown in Table 6.

**[Table 6]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 7-1 | Ti | 0.1 | W | 1.0 | 3 | Cu-Mo | 3 | Excellent | Excellent |
| Example 7-2 | Ti | 0.1 | W | 1.0 | 1 | Cu-Mo | 10 | Excellent | Excellent |
| Example 7-3 | Ti | 0.1 | W | 1.0 | 1 | Cu-Mo | 20 | Excellent | Excellent |
| Example 7-4 | Ti | 0.1 | W | 1.0 | 1 | Cu-Mo | 30 | Excellent | Excellent |
| Example 7-5 | Ti | 0.1 | W | 1.0 | 1 | Cu-Mo | 70 | Excellent | Excellent |
| Example 7-6 | Ti | 0.1 | W | 1.0 | 1 | Cu-Mo | 88 | Good | Good |

According to the results of Examples 7-1 to 7-6 in Table 6, it was found that also when the up-and-down conduction body 4 is provided with the composite structure of Cu and Mo, an effect similar to Examples 1 and 6-1 to 6-5 can be obtained.

That is, when considering further improving the effect of suppressing creation of a crack in the metallized layers 10, 11 formed on surfaces 7, 8 of a substrate 3, an AuSn solder layer 12 formed on the metallized layer 10, and the like while suppressing creation of a void, it was found that the existence ratio of Cu in the up-and-down conduction body 4 having the composite structure of Cu and Mo is set to preferably 3 % or more, particularly preferably 10 % or more, and is set to preferably 88 % or less, particularly preferably 70 % or less.

### <Example 8>

A ceramic wiring substrate 1 comprising an up-and-down conduction body 4 having a composite structure of Ag and W where an existence ratio of Ag was 3 % (Example 8-1), 10 % (Example 8-2), 20 % (Example 8-3), 30 % (Example 8-4), 70 % (Example 8-5) and 88 % (Example 8-6) was completed in a manner similar to Example 1 except that the up-and-down conduction body was provided with a composite structure of Ag and W by infiltrating Ag into a porous structure body formed of W, and that a viscosity of a paste including a powder of W, an amount of a resin binder of the paste, and the like were adjusted, and metallized layers 10, 11 were formed and these metallized layers 10, 11 were subjected to pattern formation, then section observations 1, 2 were performed. Results are shown in Table 7.

**[Table 7]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Ag (%) | AuSn solder layer | Metallized layers |
| Example 8-1 | Ti | 0.1 | W | 1.0 | 3 | Ag-W | 3 | Excellent | Excellent |
| Example 8-2 | Ti | 0.1 | W | 1.0 | 1 | Ag-W | 10 | Excellent | Excellent |
| Example 8-3 | Ti | 0.1 | W | 1.0 | 1 | Ag-W | 20 | Excellent | Excellent |
| Example 8-4 | Ti | 0.1 | W | 1.0 | 1 | Ag-W | 30 | Excellent | Excellent |
| Example 8-5 | Ti | 0.1 | W | 1.0 | 1 | Ag-W | 70 | Excellent | Excellent |
| Example 8-6 | Ti | 0.1 | W | 1.0 | 1 | Ag-W | 88 | Good | Good |

According to the results of Examples 8-1 to 8-6 in Table 7, it was found that also when the up-and-down conduction body 4 is provided with the composite structure of Ag and W, an effect similar to Examples 1 and 6-1 to 6-5 can be obtained.

That is, when considering further improving the effect of suppressing creation of a crack in the metallized layers 10, 11 formed on surfaces 7, 8 of a substrate 3, an AuSn solder layer 12 formed on the metallized layer 10, and the like while suppressing creation of a void, it was found that the existence ratio of Ag in the up-and-down conduction body 4 having the composite structure of Ag and W is set to preferably 3 % or more, particularly preferably 10 % or more, and is set to preferably 88 % or less, particularly preferably 70 % or less.

### <Example 9>

A ceramic wiring substrate 1 comprising an up-and-down conduction body 4 having a composite structure of Ag and Mo where an existence ratio of Ag was 3 % (Example 9-1), 10 % (Example 9-2), 20 % (Example 9-3), 30 % (Example 9-4), 70 % (Example 9-5) and 88 % (Example 9-6) was completed in a manner similar to Example 1 except that the up-and-down conduction body was provided with a composite structure of Ag and Mo by infiltrating Ag into a porous structure body formed of Mo, and that a viscosity of a paste including a powder of Mo, an amount of a resin binder of the paste, and the like were adjusted, and metallized layers 10, 11 were formed and these metallized layers 10, 11 were subjected to pattern formation, then section observations 1, 2 were performed. Results are shown in Table 8.

**[Table 8]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Ag (%) | AuSn solder layer | Metallized layers |
| Example 9-1 | Ti | 0.1 | W | 1.0 | 4 | Ag-Mo | 3 | Excellent | Excellent |
| Example 9-2 | Ti | 0.1 | W | 1.0 | 1 | Ag-Mo | 10 | Excellent | Excellent |
| Example 9-3 | Ti | 0.1 | W | 1.0 | 1 | Ag-Mo | 20 | Excellent | Excellent |
| Example 9-4 | Ti | 0.1 | W | 1.0 | 1 | Ag-Mo | 30 | Excellent | Excellent |
| Example 9-5 | Ti | 0.1 | W | 1.0 | 1 | Ag-Mo | 70 | Excellent | Excellent |
| Example 9-6 | Ti | 0.1 | W | 1.0 | 1 | Ag-Mo | 88 | Good | Good |

According to the results of Examples 9-1 to 9-6 in Table 8, it was found that also when the up-and-down conduction body 4 is provided with the composite structure of Ag and Mo, an effect similar to Examples 1 and 6-1 to 6-5 can be obtained.

That is, when considering further improving the effect of suppressing creation of a crack in the metallized layers 10, 11 formed on surfaces 7, 8 of a substrate 3, an AuSn solder layer 12 formed on the metallized layer 10, and the like while suppressing creation of a void, it was found that the existence ratio of Ag in the up-and-down conduction body 4 having the composite structure of Ag and Mo is set to preferably 3 % or more, particularly preferably 10 % or more, and is set to preferably 88 % or less, particularly preferably 70 % or less.

### <Example 10>

A ceramic wiring substrate 1 comprising an up-and-down conduction body 4 having a composite structure of Au and W where an existence ratio of Au was 3 % (Example 10-1), 10 % (Example 10-2), 20 % (Example 10-3), 30 % (Example 10-4), 70 % (Example 10-5) and 88 % (Example 10-6) was completed in a manner similar to Example 1 except that the up-and-down conduction body was provided with a composite structure of Au and W by infiltrating Au into a porous structure body formed of W, and that a viscosity of a paste including a powder of W, an amount of a resin binder of the paste, and the like were adjusted, and metallized layers 10, 11 were formed and these metallized layers 10, 11 were subjected to pattern formation, then section observations 1, 2 were performed. Results are shown in Table 9.

**[Table 9]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Au (%) | AuSn solder layer | Metallized layers |
| Example 10-1 | Ti | 0.1 | W | 1.0 | 4 | Au-W | 3 | Excellent | Excellent |
| Example 10-2 | Ti | 0.1 | W | 1.0 | 1 | Au-W | 10 | Excellent | Excellent |
| Example 10-3 | Ti | 0.1 | W | 1.0 | 1 | Au-W | 20 | Excellent | Excellent |
| Example 10-4 | Ti | 0.1 | W | 1.0 | 1 | Au-W | 30 | Excellent | Excellent |
| Example 10-5 | Ti | 0.1 | W | 1.0 | 1 | Au-W | 70 | Excellent | Excellent |
| Example 10-6 | Ti | 0.1 | W | 1.0 | 1 | Au-W | 88 | Good | Good |

According to the results of Examples 10-1 to 10-6 in Table 9, it was found that also when the up-and-down conduction body 4 is provided with the composite structure of Au and W, an effect similar to Examples 1 and 6-1 to 6-5 can be obtained.

That is, when considering further improving the effect of suppressing creation of a crack in the metallized layers 10, 11 formed on surfaces 7, 8 of a substrate 3, an AuSn solder layer 12 formed on the metallized layer 10, and the like while suppressing creation of a void, it was found that the existence ratio of Au in the up-and-down conduction body 4 having the composite structure of Au and W is set to preferably 3 % or more, particularly preferably 10 % or more, and is set to preferably 88 % or less, particularly preferably 70 % or less.

### <Example 11>

A ceramic wiring substrate 1 comprising an up-and-down conduction body 4 having a composite structure of Au and Mo where an existence ratio of Au was 3 % (Example 11-1), 10 % (Example 11-2), 20 % (Example 11-3), 30 % (Example 11-4), 70 % (Example 11-5) and 88 % (Example 11-6) was completed in a manner similar to Example 1 except that the up-and-down conduction body was provided with a composite structure of Au and Mo by infiltrating Au into a porous structure body formed of Mo, and that a viscosity of a paste including a powder of Mo, an amount of a resin binder of the paste, and the like were adjusted, and metallized layers 10, 11 were formed and these metallized layers 10, 11 were subjected to pattern formation, then section observations 1, 2 were performed. Results are shown in Table 10.

**[Table 10]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Au (%) | AuSn solder layer | Metallized layers |
| Example 11-1 | Ti | 0.1 | W | 1.0 | 4 | Au-Mo | 3 | Excellent | Excellent |
| Example 11-2 | Ti | 0.1 | W | 1.0 | 1 | Au-Mo | 10 | Excellent | Excellent |
| Example 11-3 | Ti | 0.1 | W | 1.0 | 1 | Au-Mo | 20 | Excellent | Excellent |
| Example 11-4 | Ti | 0.1 | W | 1.0 | 1 | Au-Mo | 30 | Excellent | Excellent |
| Example 11-5 | Ti | 0.1 | W | 1.0 | 1 | Au-Mo | 70 | Excellent | Excellent |
| Example 11-6 | Ti | 0.1 | W | 1.0 | 1 | Au-Mo | 88 | Good | Good |

According to the results of Examples 11-1 to 11-6 in Table 8, it was found that also when the up-and-down conduction body 4 is provided with the composite structure of Au and Mo, an effect similar to Examples 1 and 6-1 to 6-5 can be obtained.

That is, when considering further improving the effect of suppressing creation of a crack in the metallized layers 10, 11 formed on surfaces 7, 8 of a substrate 3, an AuSn solder layer 12 formed on the metallized layer 10, and the like while suppressing creation of a void, it was found that the existence ratio of Au in the up-and-down conduction body 4 having the composite structure of Au and MO is set to preferably 3 % or more, particularly preferably 10 % or more, and is set to preferably 88 % or less, particularly preferably 70 % or less.

### <Example 12>

A ceramic wiring substrate 1 was completed in a manner similar to Example 1 except that a Co film (Example 12-1), a Fe film (Example 12-2), a Zr film (Example 12-3), a Ta film (Example 12-4), an Nb film (Example 12-5) or an Hf film (Example 12-6) each having a thickness of 0.1 µm was formed as an intermediate layer 5, and metallized layers 10, 11 were formed and these metallized layers 10, 11 were subjected to pattern formation, then section observations 1, 2 were performed. Results are shown along with the results of Example 1 in Table 11.

**[Table 11]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 1 | Ti | 0.1 | W | 1.0 | 1 | Cu-W | 30 | Excellent | Excellent |
| Example 12-1 | Ti | 0.1 | Co | 1.0 | 1 | Cu-W | 30 | Excellent | Excellent |
| Example 12-2 | Ti | 0.1 | Fe | 1.0 | 1 | Cu-W | 30 | Excellent | Excellent |
| Example 12-3 | Ti | 0.1 | Zr | 1.0 | 1 | Cu-W | 30 | Excellent | Excellent |
| Example 12-4 | Ti | 0.1 | Ta | 1.0 | 1 | Cu-W | 30 | Excellent | Excellent |
| Example 12-5 | Ti | 0.1 | Nb | 1.0 | 1 | Cu-W | 30 | Excellent | Excellent |
| Example 12-6 | Ti | 0.1 | Hf | 1.0 | 1 | Cu-W | 30 | Excellent | Excellent |

According to the results in Table 11, it was found that not only W but also Co, Fe, Zr Ta, Nb and Hf can function in the same way as the intermediate layer 5.

### <Example 13>

A ceramic wiring substrate 1 was completed in a manner similar to Example 1 except that a Re film (Example 13-1), an Os film (Example 13-2), an Ir film (Example 13-3) and a Ru film (Example 13-4) respectively having a thickness of 0.1 µm were formed as an intermediate layer 5, and that a vacuum deposition method was employed as a film formation method of an adhesive layer 6 and the intermediate layer 5, and metallized layers 10, 11 were formed and these metallized layers 10, 11 were subjected to pattern formation, then section observations 1, 2 were performed. Results are shown along with the results of Example 1 in Table 12.

Additionally, the film formation by a vacuum deposition method was performed using a powder of each element or a wire as an evaporation source, at an ultimate vacuum of 1×10⁻⁵ Pa, by heating and dissolving the evaporation source in a crucible through an electron beam.

**[Table 12]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 1 | Ti | 0.1 | W | 1.0 | 1 | Cu-W | 30 | Excellent | Excellent |
| Example 13-1 | Ti | 0.1 | Re | 1.0 | 1 | Cu-W | 30 | Excellent | Excellent |
| Example 13-2 | Ti | 0.1 | Os | 1.0 | 1 | Cu-W | 30 | Excellent | Excellent |
| Example 13-3 | Ti | 0.1 | Ir | 1.0 | 1 | Cu-W | 30 | Excellent | Excellent |
| Example 13-4 | Ti | 0.1 | Ru | 1.0 | 1 | Cu-W | 30 | Excellent | Excellent |

According to the results in Table 12, it was found that Re, Os, Ir and Ru can function in the same way as the intermediate layer 5.

### <Example 14>

Section observations 1, 2 were performed in a manner similar to Example 1 except that in place of an AuSn solder film, an AuSn solder layer 12 having a thickness of 5 µm by a vacuum deposition method was formed on a metallized layer 10 (Example 14-4) .

Further, section observations 1, 2 were performed in a manner similar to Example 14-4 except that an existence ratio of Cu in an up-and-down conduction body 4 having a composite structure of Cu and W was set to 3 % (Example 14-1), 10 % (Example 14-2), 20 % (Example 14-3), 50 % (Example 14-5), 70 % (Example 14-6) and 88 % (Example 14-7) by adjusting a viscosity of a paste including a W powder which was to become a porous structure body, an amount of a resin binder of the paste, and the like.

Results are shown in Table 13.

**[Table 13]**

| | Adhesive layer 6 | | Intermediate layer 5 | | Occurrence ratio of void (%) | Up-and-down conduction body 4 | | Crack | |
|---|---|---|---|---|---|---|---|---|---|
| | Type | Thickness (µm) | Type | Thickness (µm) | | Type | Cu (%) | AuSn solder layer | Metallized layers |
| Example 14-1 | Ti | 0.1 | W | 1.0 | 4 | Cu-W | 3 | Excellent | Excellent |
| Example 14-2 | Ti | 0.1 | W | 1.0 | 1 | Cu-W | 10 | Excellent | Excellent |
| Example 14-3 | Ti | 0.1 | W | 1.0 | 1 | Cu-W | 20 | Excellent | Excellent |
| Example 14-4 | Ti | 0.1 | W | 1.0 | 1 | Cu-W | 30 | Excellent | Excellent |
| Example 14-5 | Ti | 0.1 | W | 1.0 | 1 | Cu-W | 50 | Excellent | Excellent |
| Example 14-6 | Ti | 0.1 | W | 1.0 | 1 | Cu-W | 70 | Good | Excellent |
| Example 14-7 | Ti | 0.1 | W | 1.0 | 1 | Cu-W | 88 | Good | Good |

According to the results in Table 14, it was found that by setting the existence ratio of Cu in the up-and-down conduction body 4 to 50 % or less when the thickness of the AuSn solder layer 12 is 8 µm or less, creation of a crack in the AuSn layer 12 and the metallized layer 10 can be more reliably prevented.

### Reference Signs List

- 1: ceramic wiring substrate
- 2: up-and-down conduction hole
- 3: substrate
- 4: up-and-down conduction body
- 5: intermediate layer
- 6: adhesive layer
- 7, 8: surfaces
- 9: semiconductor device
- 10, 11: metallized layers
- 12: solder layer
- 13: semiconductor element

## Claims

1. A ceramic wiring substrate, comprising:
a substrate formed in a plate shape by sintering a ceramic precursor including at least one selected from a group consisting of Al and Si;
an up-and-down conduction hole formed by penetrating the substrate in a thickness direction thereof after sintering the substrate;
an up-and-down conduction body which is formed of a composite material including at least one low-resistance metal selected from a group consisting of Cu, Ag and Au and at least one high melting point metal selected from a group consisting of W and Mo, and is filled in the up-and-down conduction hole; and
an intermediate layer which is provided by separating the up-and-down conduction body and the substrate therebetween and is formed of at least one selected from a group consisting of Mo, W, Co, Fe, Zr, Re, Os, Ta, Nb, Ir, Ru and Hf.

2. A ceramic wiring substrate according to claim 1, wherein a thickness of the intermediate layer is 0.1 µm or more.

3. A ceramic wiring substrate according to claim 1 or 2, wherein the substrate comprises a solder layer on at least one flat surface,
a thickness of the solder layer is 8 µm or less, and
a proportion of the low-resistance metal in the up-and-down conduction body is 50 % or less.

4. A semiconductor device, wherein a semiconductor element is mounted on the ceramic wiring substrate according to any one of claims 1 to 3.

5. A method for manufacturing the ceramic wiring substrate according to any one of claims 1 to 3, including steps of:
forming the substrate by sintering a plate body of a precursor which is to become ceramic forming the substrate;
forming an up-and-down conduction hole by penetrating the substrate in a thickness direction thereof;
forming the intermediate layer made of at least one selected from a group consisting of Mo, W, Co, Fe, Zr, Re, Os, Ta, Nb, Ir, Ru and Hf on an inner surface of the up-and-down conduction hole;
filling in the up-and-down conduction hole a paste including a powder of the at least one high melting point metal selected from a group consisting of W and Mo, and sintering the powder, thereby to form a porous structure body made of the high melting point metal; and
forming the up-and-down conduction body by infiltrating the at least one low-resistance metal selected from a group consisting of Cu, Ag and Au into the porous structure body.
